# FASCICULE DE BREVET EUROPEEN

(11) **EP 2 151 010 B1**
(45) Date de publication et mention de la délivrance du brevet: **01.11.2017**
(21) Numéro de dépôt: 08759557.5
(22) Date de dépôt: 13.05.2008
(51) Int. Cl.: H01Q 1/22, G06K 19/077

(54) **PROCÉDÉ DE RÉALISATION D'UN DISPOSITIF COMPORTANT UNE ANTENNE DE TRANSPONDEUR CONNECTÉE À DES PLAGES DE CONTACT ET DISPOSITIF OBTENU**
VERFAHREN ZUR HERSTELLUNG EINER VORRICHTUNG, DIE EINE TRANSPONDERANTENNE VERBUNDEN MIT KONTAKTBEREICHEN UMFASST, UND SO ERHALTENE VORRICHTUNG
METHOD OF MANUFACTURING A DEVICE COMPRISING A TRANSPONDER ANTENNA CONNECTED TO CONNECTING PADS AND DEVICE OBTAINED

(30) Priorité: 21.05.2007 EP 07301057
(43) Date de publication de la demande: 10.02.2010
(73) Titulaire: Gemalto SA, 92190 Meudon (FR)
(72) Inventeur: MARTINENT, Jean-François, 13090 Aix En Provence (FR); ROBLES, Laurence, 83640 Saint Zacharie (FR); ROUSSEL, François, 92330 Sceaux (FR)
(74) Mandataire: Milharo, Emilien
(86) Numéro de dépôt international: PCT/EP2008/055859
(87) Numéro de publication internationale: WO 2008/141982

(56) Documents cités:
- EP-A- 0 913 268
- WO-A-00/30210
- FR-A- 2 782 821
- US-A- 5 528 222

## Description

L'invention concerne le domaine des transpondeurs radiofréquences. En particulier, il concerne un procédé de réalisation d'un dispositif comportant une antenne de transpondeur connectée à des plages de contact et le dispositif obtenu.

Le procédé ci-dessus, comporte en particulier, une étape de connexion de l'antenne à des plages de contact, ces dernières étant éventuellement connectées à un microcircuit, tel une puce électronique ou un module.

L'invention vise à être utilisée en principalement dans la fabrication d'un insert électronique radiofréquence de faible épaisseur et bas coût et présentant de préférence de bonnes propriétés de communication notamment de portée.

Un tel insert comporte au moins une antenne sur un substrat connectée à un microcircuit; il est destiné notamment à être inséré dans un laminé de feuilles, une couverture de passeport électronique, une carte d'identité, tout produit doté d'une fonction de communication radiofréquence; et de fait son épaisseur présente de l'importance.

Parmi différentes techniques de connexion, on connaît une connexion, la plus courante, qui est du type "wire bonding", soudure filaire à l'aide d'une sonde ultra-son qui alimente et soude du fil de connexion entre les différents points à connecter, la puce ou un composant étant disposé à côté des extrémités de l'antenne à connecter.

Cette technique a l'inconvénient de nécessiter des surfaces métalliques de connexion plates notamment gravées et un support des surfaces résistant à la pression de l'outil de soudure, une résine de protection sur les connexions pour les protéger et une feuille de compensation de l'épaisseur de la résine.

Dans une autre solution, la connexion s'effectue par matière adhésive conductrice disposée entre les extrémités de l'antenne et les connexions d'un composant, un module ou une puce étant reporté directement sur les extrémités de connexion d'une antenne, par exemple en cuivre gravée sur un substrat.

Le recours à de la matière adhésive conductrice a l'inconvénient de requérir des pistes métalliques ou spires qui soient nues et le croisement des spires requiert des gravures en double face ou une étape de réalisation d'un pont isolant.

On connaît un procédé de réalisation d'une antenne connectée par point de couture par la demande de brevet JP 2002 298110 A, dans lequel un module est d'abord fixé sur un substrat et l'antenne est fixée ensuite par points de couture sur le substrat; et pour la connexion des modules à l'antenne, le fil s'étend par dessus les plages et vient serrer par contact des plages de contact du module.

En alternative, la connexion peut être réalisée par thermo-compression du fil d'antenne sur des plages de contact, la sonde appuyant et apportant de l'énergie thermique directement sur le fil.

Dans d'autres cas comme dans le brevet EP 0880 754 B1, le fil d'antenne réalisé en fil incrusté dans une feuille polymère, survole les plages de contact d'une puce déjà en place ou son emplacement correspondant avant une connexion par soudure notamment ultra son ou thermo compression directement en appuyant et apportant de l'énergie directement sur le fil.

Quand il s'agit de survoler des emplacements de plots de connexion, le substrat est fourni avec une cavité de réception d'une puce électronique ou un module. En cours de réalisation, l'outil d'incrustation stoppe l'incrustation avant la cavité, survole la cavité et fixe à nouveau le fil après la cavité; ensuite, la puce ou un module est introduit par dessous la cavité de manière que les plots de la puce soient en regard des fils avant de réaliser la connexion par soudure.

Ce procédé a l'inconvénient d'être long et de nécessiter une cavité préalablement à la réalisation de l'antenne.

Quant à la présence du module sur le substrat avant la réalisation de l'antenne, elle peut être un frein à la cadence de production de l'antenne en grande série pour certains procédés de réalisation d'antenne.

Dans le brevet EP 1328899 B1, l'antenne est réalisée à l'aide d'un fil métallique cousu sur une feuille et des pastilles de contact sont disposées préalablement sur la feuille et cousues avec le fil d'antenne. Une puce est reportée sur le substrat et connecté notamment par une liaison par fil soudé "wire bonding" aux pastilles. Cette technique requiert un positionnement préalable contraignant des pastilles et d'enrober les connexions ultérieurement comme indiqué précédemment. Dans le brevet FR 2 782 821, le procédé de fabrication d'une carte à puce prévoit prévoit de réaliser un ensemble comprenant un module électronique et une antenne. La connexion de la puce ou du module s'effectue par flip-chip ou par colle conductrice ou avec des fils soudés.

L'invention vise à résoudre les inconvénients précités de la connexion d'un microcircuit à une antenne en particulier dans le cadre de la réalisation d'un insert électronique radiofréquence de faible épaisseur et bas coût présentant de bonnes propriétés de communication notamment de portée.

A cet effet, l'invention a pour objet un procédé de réalisation d'un dispositif comportant une antenne de transpondeur connectée à des plages de contact, ledit procédé comportant des étapes de :
- réalisation d'une antenne comportant des portions terminales de connexion reposant sur un substrat,
- report des plages de contact sur le substrat et leur connexion aux portions terminales de l'antenne, la connexion étant réalisée sous forme d'une soudure par apport d'énergie entre les plages et les portions terminales;

Le procédé se distingue en ce que les plages sont reportées de manière à présenter une surface en regard d'une portion terminale de connexion de l'antenne, ladite portion étant disposée sur le substrat, l'énergie de soudure étant appliquée directement sur les plages.

Outre la résolution des inconvénients précités, l'invention permet une souplesse de fabrication du dispositif par un découplage de la fabrication de l'antenne des autres opérations classiques de réalisation d'insert, notamment le report préalable des plages de contact sur un substrat, réalisation préalable d'une cavité sous les portions d'antenne à connecter, enrobage des connexions, éviter la pollution de l'outil de soudure.

Selon d'autres caractéristiques de mise en oeuvre, le procédé :
- l'antenne est réalisée par broderie ou couture sur un support souple comportant un tissu et en ce qu'il comprend une étape selon laquelle on dispose un matériau de renfort notamment sous forme de feuille ou couche sur une face du substrat opposée à celle portant les portions terminales;
- la couche ou feuille de renfort est disposée après réalisation de l'antenne;
- le procédé comprend une étape de formation d'une cavité dans le substrat et/ou feuille ou couche de renfort à proximité des portions terminales de connexion de l'antenne;
- le procédé comprend une étape selon laquelle on reporte les plages de contact associées à un microcircuit en regard de portions terminales de l'antenne, le microcircuit étant inséré au moins en partie dans la cavité;
- le procédé comprend une étape selon laquelle on effectue une soudure de type thermo-compression ou à ultra son;
- la soudure utilise une enclume qui vient exercer un appui contre l'enfoncement de la portion terminale de l'antenne dans le support;
- l'enclume transperce au moins la feuille ou couche de renfort en regard de la portion terminale à connecter de manière que la portion à connecter soit supportée par l'enclume pendant la soudure;
- le fil d'antenne est un fil hybride associé à au moins un fil non conducteur;

L'invention a également pour objet un dispositif comportant une antenne connectée à des plages de contact, ledit dispositif comprenant un substrat et une antenne munie de portions terminales de connexion reposant sur le substrat, ladite antenne étant connectée par soudure aux portions terminales;

Le dispositif se distingue en ce que les plages de contact électrique présentent une surface en regard d'une portion terminale de connexion de l'antenne, ladite portion étant disposée sur le substrat.

Selon d'autres caractéristiques du dispositif:
- l'antenne est réalisée par broderie ou couture sur un support souple comportant un tissu et en ce qu'il comprend un matériau de renfort sous forme de feuille ou couche sur une face du substrat opposée à celle portant les portions terminales;
- le dispositif comprend une cavité dans le substrat et/ou feuille ou couche de renfort à proximité des portions terminales de connexion de l'antenne;
- des plages de contact sont associées à un microcircuit et disposées en regard du substrat et de portions terminales de l'antenne reposant sur le substrat, tandis que le microcircuit est inséré au moins en partie dans la cavité;
- les plages comportent une marque de soudage à travers les plages sur une face des plages opposée à celle soudée;
- le dispositif comporte des perforations dans le matériau de renfort en regard de chaque de portion terminale connectée;
- le fil d'antenne est un fil hybride associé à au moins un fil non conducteur;

L'invention a également pour objet un produit électronique de communication radiofréquence, tel une carte à puce sans contact, un passeport comprenant le dispositif ci-dessus ou obtenu selon le procédé ci-dessus.

D'autres particularités et avantages de l'invention apparaîtront à la lecture de la description, qui suit, donnée à titre d'exemple illustratif et non limitatif, et faite en référence aux figures annexées pour lesquelles :
- la figure 1 illustre une vue schématique d'un transpondeur pouvant être obtenu selon un mode de mise en oeuvre du procédé de l'invention ;
- la figure 2 illustre en détail le module de circuit électronique de la figure 1, en cours de connexion à une antenne;
- la figure 3 illustre une vue en coupe d'un second mode de réalisation, l'antenne étant en fil incrusté;
- la figure 4 illustre une vue en coupe d'un troisième mode de réalisation et dans lequel la tenue du substrat est renforcé avec une feuille;
- la figure 5 illustre une vue en coupe d'un quatrième mode de réalisation montrant une connexion avec un fil d'antenne brodé;
- La figure 6 illustre une vue en coupe d'un cinquième mode de réalisation montrant une connexion avec un fil d'antenne hybride;
- la figure 7 illustre une étape lamination d'une feuille de renfort sur un support comportant une pluralité d'antenne;
- Les figures 8 et 9 illustrent les empreintes laissées par les outils de soudure et enclume sur le dispositif conforme à la figure 4;
- La figure 10 illustre une autre empreinte avec autre orientation des portions terminales de connexion par rapport au module et outil de soudure et empreintes obtenues.
- Les figures 11 et 12 illustrent une autre configuration des plages en regard du fil d'antenne et leur connexion;
- La figure 13 illustre un support tissé portant un fil d'antenne fixé par fil de broderie,
- La figure 14 illustre les étapes du procédé selon un mode préféré de mise en oeuvre.

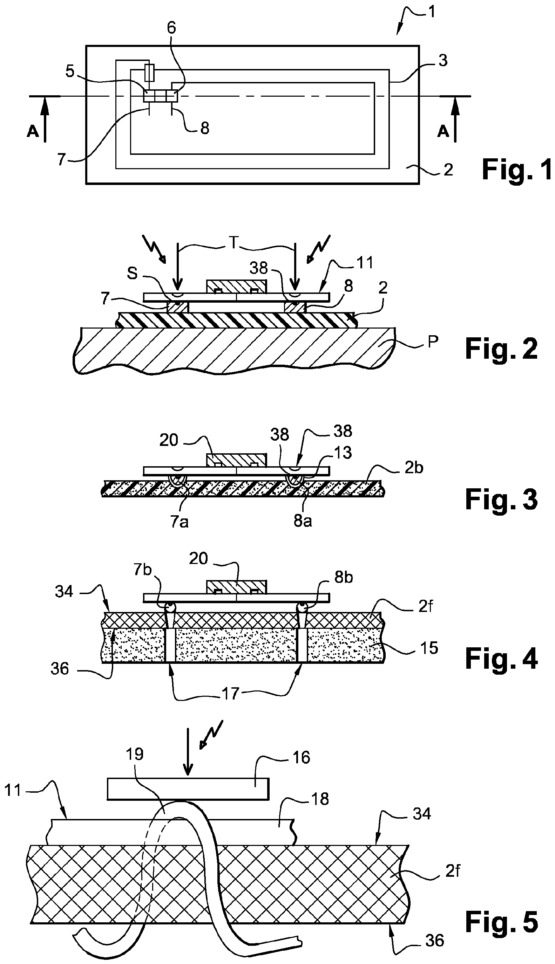

La figure 1 illustre une vue schématique d'un dispositif 1 comportant une antenne 3 connectée à des plages de contact 5, 6 pouvant être obtenu selon un mode de mise en oeuvre du procédé de l'invention.

Le dispositif comprend un substrat 2 et une antenne munie de portions terminales de connexion 7, 8 reposant sur le substrat. L'antenne étant connectée par soudure (S) aux portions terminales. L'antenne est ici réalisée par gravure électrochimique. Les pistes sont fines par rapport aux plages par exemple 2 mm de large / 5 mm. Le module peut ou non comprendre un film diélectrique support.

De préférence, les surfaces de contact métalliques 11 sur lesquelles a été appliqué (fig.2) un outil de soudure T (thermode) sont vierges de matériau pouvant polluer l'outil de soudure.

Selon un mode de réalisation de l'invention à la figure 2, contrairement à l'art antérieur où des portions de connexion survolent des plages déjà en place ou survolent un logement de puce ou module, ici les plages de contact électrique présentent une surface en regard d'une portion terminale de connexion de l'antenne qui repose sur le substrat 2. Les plages reposent sur et au contact des extrémités 7, 8 de l'antenne pendant une opération de connexion, le dispositif 1 reposant sur un plan P.

Principalement dans l'art antérieur, les connexions puce avec des antennes gravées sont réalisées avec de la colle conductrice ou non conductrice mais avec des plots sur la puce, celle-ci étant reporté sur l'antenne ou par fils soudés la puce étant disposé par dessus.

A la figure 3, avec la même configuration de report de plages ou de module comme à la figure 2. L'antenne est réalisée par incrustation de fil conducteur sur une feuille polymère 2b. Le fil conducteur peut être enrobé d'un vernis ou gaine isolante 13.

A la figure 4, toujours avec la même configuration de report, l'antenne est réalisée par broderie ou couture sur un support souple comportant un tissu 2f. Le support est souple dans la mesure où il n'a pas de tenue, de rigidité comme tous les tissus fins. Le maillage (m) lâche entre des fils de chaine et trame est par exemple compris entre 200 µm et 300 µm dans les deux sens) avec un fil en polyamide de 80µm d'épaisseur ou de 48dtex. En outre, le tissu 2f n'est pas stable dimensionnellement dans la mesure où il peut s'étirer normalement à la main notamment en diagonale par exemple au moins de 3 % à 20 %. Cette élongation est inférieure à 1 % dans le sens du défilement du substrat sens chaine ou trame sous une tension de défilement en production.

Le maniement du tissu support d'une antenne brodée étant très délicat (matériau tissé souple et poreux), il est prévu de le stabiliser avec un matériau de renfort 15, sous forme de feuille ou couche, disposée sur une face du substrat opposée à celle portant les portions terminales de l'antenne; On procède à la fixation d'un matériau stabilisant 15 par adjonction d'une feuille plastique poreuse telle que celle connue sous la marque Teslin ou du papier synthétique.

De préférence, l'adjonction de la feuille de renfort est effectuée après la réalisation de l'antenne de manière à ne pas gêner les cadences de production d'antenne brodées. Mais pourrait être réalisée avant, le cas échéant avec des rendements moins intéressants et risques d'endommagement des aiguilles du métier à broder ou à coudre etc...

Un effet semblable à l'ajout d'une feuille peut être obtenu par imprégnation ou enduction d'une couche ou pulvérisation d'un produit tel un enduit, un apprêt, une résine, une mousse polymère, une gomme, apte à stabiliser dimensionnellement le substrat.

L'assemblage peut être réalisé par lamination, soudure thermique (fusion des matériaux) ou addition d'un adhésif (en film, liquide). Le substrat étant très fin pour des questions de productivité et facilité de mise en oeuvre.

Cette étape permet également de conférer plus d'épaisseur au substrat pour permettre une réception d'une partie au moins d'un composant dans le support lors du report de ce dernier.

Le dispositif comporte des perforations 17, éventuellement refermées en partie, dans le matériau de renfort en regard de chaque connexion et portion terminale 7b, 8b, connectée ainsi qu'il résulte de l'utilisation d'une enclume très fine ou aiguille appliquée sous le fil conducteur à connecter et qui perfore le matériau comme expliqué ultérieurement.

A la figure 5 une plage seule 16, non encore connectée à un microcircuit, est reportée sur une portion terminale d'antenne filaire 18 brodée avec un fil de broderie 19 pour la fixation de l'antenne sur le support fibreux 2f. La connexion à un microcircuit 20 à la plage pourra s'effectuer ultérieurement par tout moyen connu, notamment par puce retournée (flip-chip).

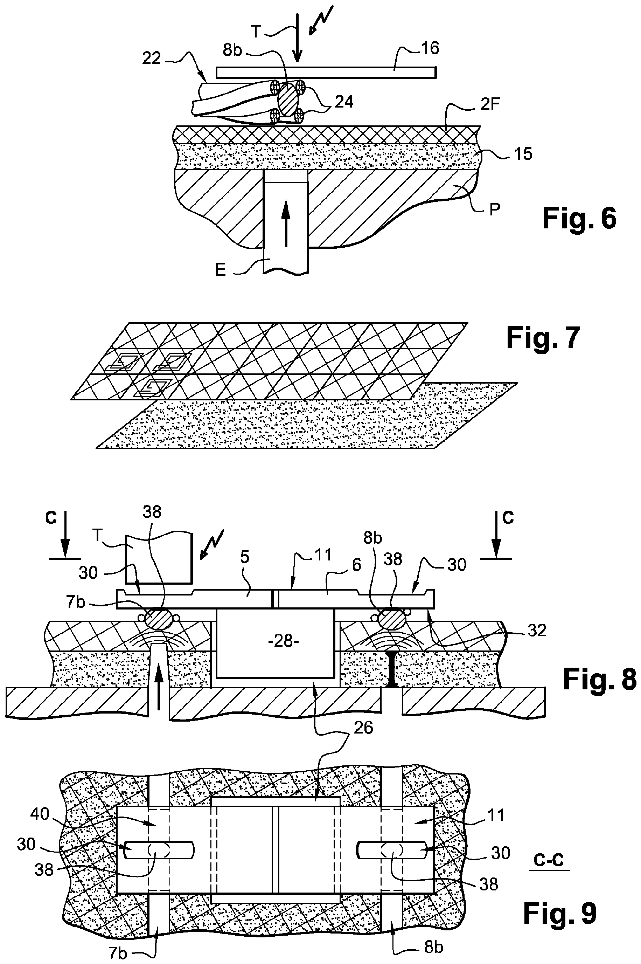

A la figure 6, un cinquième mode de réalisation le dispositif comporte une connexion avec un fil d'antenne hybride 22 dans la mesure où le fil d'antenne 3 est associé à quatre fils non conducteurs 24; l'association peut cependant en compter au moins un fil non conducteur 24. Les fils non conducteurs 24 sont de préférence thermo-fusibles ou thermoplastiques pour fondre sous l'effet de l'énergie thermique ou énergie des ultra-sons.

A cause de la présence des fils non conducteurs 19 et 24, selon l'invention, on applique l'outil (thermode) (T) sur la plage métallique 16 ce qui a pour effet de faire fondre le fil de fixation et/ou fil associés passant dessous et ce sans pollution de l'outil de soudage. De préférence, une enclume vient supporter le fil d'antenne pendant la connexion.

Sur les figures 8 et 9, le dispositif comprend une cavité 26 dans le substrat et/ou feuille ou couche de renfort à proximité des portions terminales de connexion de l'antenne. Des plages de contact 5, 6 sont associées à un microcircuit enrobé 28. Le microcircuit est inséré au moins en partie dans la cavité diminuant ainsi l'épaisseur totale du dispositif.

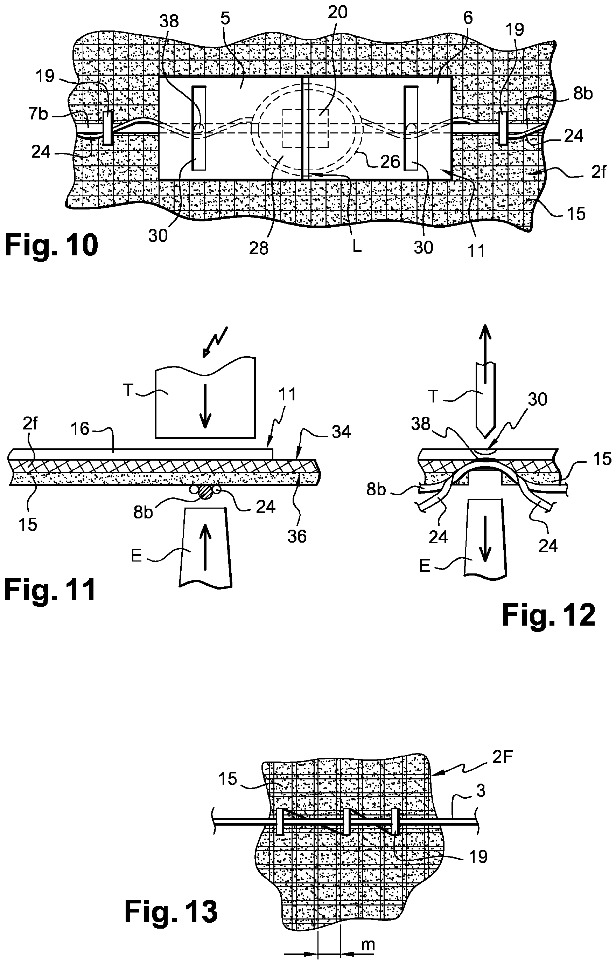

On voit que les plages 5, 6 comportent une marque 30 de l'outil de soudage T et soudage 38 exercé à travers les plages 5, 6 sur une face 11 des plages opposée à celle 32 soudée au fil;
A la figure 10, on a une autre configuration des fils d'antenne 7a, 7b par rapport aux plages de contact 5, 6; Les extrémités arrivent face à face en direction de la puce. L'application de l'outil de connexion T s'est effectué transversalement au fil et aux plages, il en résulte deux marques 30 correspondantes sur le dessus des plages (face libre 11). Les marques sont parallèles entre elles et parallèles à une ligne L de séparation des plages 5 et 6.

Sur les figures 11 et 12, une autre configuration du dispositif est telle que le fil d'antenne 8b est disposé à l'aplomb de la plage mais sur la face du support 15 voire 2f (si le tissu est manipulable) opposée à celle portant la plage de contact 16. Dans ce cas l'enclume E très fine pousse le fil d'antenne contre la plage de contact à travers le support en faisant fluer le matériau 15 du support et/ou en écartant les mailles du support fibreux 2f associé ou non à un matériau de renfort 15.

A la figure 13, un tissu comporte des fils de chaine et de trame avec un maillage (m) lâche compris entre 200 µm et 300 µm) et composé de fils polyamide de 48 dtex.

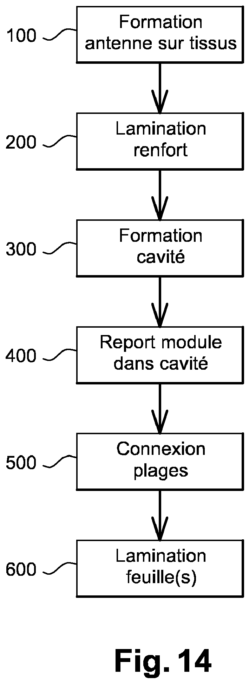

En référence à la figure 14, sera décrit maintenant un mode de mise en oeuvre préféré du procédé de l'invention permettant de satisfaire les objectifs, mais en présentant au préalable les difficultés rencontrées.

Pour la fabrication d'insert bas coût, les inventeurs ont sélectionné notamment des antennes filaires par exemple cousues, brodés ou équivalents sur support comprenant des tissus.

En particulier, en broderie notamment pour des questions de productivité et facilité de mise en oeuvre, plusieurs antennes sont d'abord réalisées en même temps sur des bancs à broder de préférence sur un support textile, fibreux tel un tissu, tissé, non tissé, ou support accepté par les machines à broder ou à coudre.

Cependant, ne sont pas exclus tout matériau apte à être cousu ou brodé comprenant par exemple d'autres substrats isolants tels que un film ou feuille en matériau polymère, en PVC, PET (polyéthylène), papier, polyimide, cuir synthétique notamment en composite fibre / tissu et feuille polymère.

Pour des questions de discrétion du dispositif, ultérieurement laminé ou ajouté à un objet, mais aussi de productivité et facilité de couture ou broderie, le support est un tissu très fin. Le substrat du dispositif au final, peut avoir différentes épaisseurs, généralement inférieures ou égales à celle d'une carte à puce de 0,76 mm de manière le cas échéant à servir d'insert entre deux films ou feuilles ou servir de support à une feuille de couverture et/ou d'impression. Typiquement le substrat peut avoir une épaisseur allant par exemple de 0,1 mm à 0,5 mm.

Les inventeurs ont noté une absence de stabilité dimensionnelle ou tenue de certains substrats notamment en tissu convenant à cette production en série notamment lorsqu'ils sont continus et en défilement. Ce manque de tenue rend difficile voire impossible un positionnement précis des modules, microcircuits ou des plages de contact ou des cavités notamment par indexation sur le substrat, avant où après la réalisation des antennes.

L'ajout d'une feuille ou matériau de renfort ou autre tissu au substrat, avec éventuellement des cavités de réception de modules préétablies tel qu'imaginé par les inventeurs, apporterait de la stabilité dimensionnelle au substrat mais présente aussi des inconvénients : du fait du manque de tenue du substrat et indexation difficile, les cavités risquent d'être mal positionnées.

Ajouter la feuille avant de réaliser l'antenne n'est pas favorable au rendement en broderie. A l'inverse, l'ajout de ce renfort, sans cavité, apporterait de la stabilité dimensionnelle au substrat, mais cela augmenterait la difficulté de connexion par ultra-son ou thermo-compression dans la mesure où il n'y aurait pas de cavité pour introduire une puce ou module et rapprocher les plages de contact des portions de connexions de l'antenne et réaliser une bonne soudure.

Les inventeurs ont trouvé que les composants électroniques ou plages de contact doivent être de préférence reportés sur le substrat après réalisation de l'antenne pour des raisons de facilité de couture de l'antenne, cadence de production, difficulté de placement et de connexion du module, permettant de réaliser une antenne économique.

En outre, l'antenne pouvant être gainée d'un isolant notamment pour réaliser un pont isolant croisant les spires ou pouvant être associée à des fils ou fibres non conducteurs pour des raisons notamment de solidité, prévention de casse de fil ou de fixation sur le support. Dans ce cas, il peut se produire des souillures, pollution de l'outil de soudure lors de la connexion par soudure à ultra-sons ou thermo compression puisque l'outil de soudure (thermode) est appliquée directement sur le fil, et se trouve mis au contact des matériaux polluants entourant le fil d'antenne dans une configuration ou le module est reporté à côté des spires de l'antenne ou en dessous.

En outre, comme l'antenne filaire repose sur le substrat, et que les inventeurs ont choisi un report et connexion des plages effectuées par dessus l'antenne, cette dernière peut avoir tendance à enfoncer dans la feuille ou masse fibreuse ajoutée sous l'effet de la pression des moyens de soudure selon la nature des matériaux utilisés.

Après ces considérations, le procédé de la figure est élaboré comme ci-après.

A l'étape 100, le procédé de réalisation d'un dispositif comportant une antenne de transpondeur connectée à des plages de contact comporte une étape de fourniture ou réalisation d'une antenne avec des portions terminales de connexion reposant sur un substrat.

L'antenne est réalisée de préférence par broderie ou couture sur un support souple comportant un tissu;
Le fil d'antenne peut comporter au moins un revêtement isolant sur toute sa surface; Il peut aussi cumulativement ou alternativement être au contact de fils isolants par endroits. Le fil d'antenne est fixé sur le substrat à l'aide d'un fil non conducteur, dit fil de broderie ou de couture.

De préférence, le fil d'antenne est un fil hybride associé à au moins un fil non conducteur pour permettre notamment une meilleure cadence sans cassure du fil.

Ce fil non conducteur entoure au moins par endroit le fil d'antenne et constitue en quelque sorte un gainage isolant par endroit.

De préférence, le fil non conducteur est thermo fusible ou thermoplastique pour permettre leur retrait ou élimination au niveau de la zone de soudure.

Des fils non thermo fusibles peuvent convenir dès l'instant où l'énergie de la soudure est suffisante pour les éliminer, les dégrader (ou qu'une matière de brasure suffisante est ajoutée pour passer à travers).

Toutefois, d'autres techniques de fixation du fil conducteur sur un substrat peuvent être choisies parmi d'autres moins performantes comme l'incrustation, ou gravure.

La réalisation de l'antenne en broderie peut comprendre de préférence une étape de réalisation d'un point d'arrêt (non représenté) de fil d'antenne de couture, de broderie, tricotage en bout de l'une au moins des dites portions terminales; puis de préférence une étape d'élimination dudit point d'arrêt comprenant éventuellement une élimination de matière du support en regard du point d'arrêt et formation éventuelle d'une cavité. Les portions terminales de l'antenne ou points d'arrêt peuvent être superposés ou réalisées dans une zone du support destinée à être éliminée. En cas d'élimination, d'un point d'arrêt par poinçonnage la portion terminale correspondante s'étend jusqu'au bord d'une cavité.

Comme indiqués précédemment, le support est de préférence un tissu très fin, mais d'autres supports fins sont envisageables

A l'étape 200 ensuite, selon une caractéristique, le procédé comporte une étape selon laquelle on dispose un matériau de renfort sous forme de feuille ou couche sur une face du substrat opposée à celle portant les portions terminales.

La couche ou feuille de renfort est disposée dans l'exemple directement après réalisation de l'antenne.

Comme déjà mentionné, un effet semblable à l'ajout d'une feuille peut être obtenu par imprégnation ou enduction d'une couche ou pulvérisation d'un produit tel un enduit, un apprêt, une résine, une mousse polymère, une gomme, apte à stabiliser dimensionnellement le substrat.

A l'étape 300, le support étant stabilisé, il est alors possible de le manipuler et d'effectuer des opérations plus classiques comme notamment reporter avec plus de facilité des plages de contact sur le substrat.

Cependant, il est préféré selon une autre caractéristique, de procéder à une étape de formation d'une cavité dans le substrat et/ou feuille ou couche de renfort à proximité des portions terminales de connexion de l'antenne de manière à introduire la puce ou module.

La cavité est réalisée par poinçonnage mais, on pourrait envisager un formage par pression ou emboutissage ou autre usinage au moins partiel du substrat.

A l'étape 400, les plages sont reportées de manière à présenter une surface en regard d'une portion terminale de connexion de l'antenne reposant sur le substrat; Le cas échéant, une puce peut être reportée notamment par puce retournée sur les plages ou face arrière sur le substrat ou sur une plage de contact pour une connexion classique par tout moyen connu, voire même de type à fil soudé.

La surface en regard et utilisé dans la description correspond à une projection de la section longitudinale d'un fil sur une plage de connexion 8b, soit un rectangle généralement large du diamètre du fil et long de la longueur de la plage parcouru en regard.

De préférence, les plages sont déjà connectées à un microcircuit électronique tel une puce; Et le microcircuit est inséré au moins en partie dans la cavité, les plages restant en dehors de la cavité en reposant sur les portions de pistes ou extrémités terminales d'antenne reposant elles-mêmes sur le support.

A l'étape 500, on effectue la connexion des plages aux portions terminales de l'antenne; La connexion est réalisée sous forme d'une soudure par apport d'énergie entre les plages et les portions terminales, l'énergie de soudure est appliquée directement sur les plages à l'aide d'une thermode pour une soudure de type thermo-compression ou d'une sonde à ultra-son pour une soudure à ultra-son.

Pour la soudure, on utilise de préférence une enclume qui vient exercer un appui contre l'enfoncement de la portion terminale de l'antenne dans le support. L'enclume est d'autant plus recommandée que le fil d'antenne a tendance à s'enfoncer dans le substrat de part la finesse du fil et/ou mollesse du substrat et/ou matériau de renfort.

L'enclume transperce au moins la feuille ou couche de renfort en regard de la portion terminale à connecter de manière que la portion à connecter soit upportée par l'enclume pendant la soudure. La section de l'enclume est rectangulaire ou carrée d'une section de l'ordre de 0,3 x 1 mm² à 1 x 5 mm².

L'invention s'applique notamment dès l'instant où on doit effectuer, en quelque sorte "en aveugle", une connexion de plage métallique directement sur une piste d'antenne ou portion terminale d'antenne également métallique et disposé sur un support moins dur que le métal, par soudure, avec ou sans apport de matière de brasure, l'inverse étant une opération classique. A priori, lors de la soudure, la pression que répercute une piste ou portion terminale sur son support est plus importante que celle répercutée par une plage du fait du rapport et de pression de surface. Ce qui dissuade l'homme de l'art d'opter pour une configuration de connexion inverse à la normale.

A l'étape 600, on assemble le support avec au moins une feuille sur le côté opposé à la feuille de renfort. Les feuilles peuvent par exemple être constituées en matériaux utilisés pour les feuilles ou couverture de passeport ou carte à puce ou autre objet. On procéde ensuite à des découpes au format. Le cas échéant, la découpe peut s'effectuer à d'autres étapes.

## Revendications

1. Procédé de réalisation d'un dispositif comportant une antenne de transpondeur connectée à des plages de contact, ledit procédé comportant des étapes de :
- réalisation d'une antenne (3) comportant des portions terminales (7b, 8b) de connexion reposant sur un substrat,
- report des plages de contact (5, 6) sur le substrat et leur connexion aux portions terminales de l'antenne (7b, 8b), la connexion étant réalisée sous forme d'une soudure (38) par apport d'énergie entre les plages (5, 6) et les portions terminales (7b, 8b),
**caractérisé en ce que** les plages (5, 6) sont reportées de manière à présenter une surface (40) en regard d'une portion terminale (7b, 8b) de connexion de l'antenne, l'énergie de soudure étant appliquée directement sur les plages (5, 6).

2. Procédé selon la revendication 1, **caractérisé en ce que** l'antenne est réalisée par broderie ou couture sur un support souple (2f) comportant un tissu et **en ce qu'**il comprend une étape selon laquelle on dispose un matériau de renfort (15) sous forme de feuille ou couche sur une face (36) du substrat opposée à celle (34) portant les portions terminales.

3. Procédé selon la revendication 2, **caractérisé en ce que** la couche ou feuille de renfort est disposée après réalisation de l'antenne.

4. Procédé selon l'une des revendications précédentes, **caractérisé en ce que** le procédé comprend une étape de formation d'une cavité (26) dans le substrat et/ou feuille ou couche de renfort à proximité des portions terminales (7b, 8b) de connexion de l'antenne.

5. Procédé selon la revendication 4, **caractérisé en ce que** le procédé comprend une étape selon laquelle on reporte les plages de contact associées à un microcircuit (20) en regard de portions terminales (7b, 8b) de l'antenne, le microcircuit étant inséré au moins en partie dans la cavité (26).

6. Procédé selon l'une des revendications précédentes, **caractérisé en ce que** le procédé comprend une étape selon laquelle on effectue une soudure (38) de type thermo-compression ou à ultra son.

7. Procédé selon la revendication 6, **caractérisé en ce que** la soudure utilise une enclume (E) qui vient exercer un appui contre l'enfoncement de la portion terminale de l'antenne dans le support.

8. Procédé selon la revendication 7, **caractérisé en ce que** l'enclume transperce d'un trou (17) au moins la feuille ou couche de renfort (15) en regard de la portion terminale à connecter de manière que la portion (7b, 8b) à connecter soit supportée par l'enclume pendant la soudure.

9. Procédé l'une des revendications précédentes, **caractérisé en ce que** le fil d'antenne (3) comporte au moins un revêtement isolant (13) sur toute sa surface et/ou est au contact de fils isolants par endroits.

10. Procédé selon l'une des revendications précédentes, **caractérisé en ce que** le fil d'antenne est fixé sur le substrat à l'aide d'un fil non conducteur (19).

11. Procédé l'une des revendications précédentes, **caractérisé en ce que** le fil d'antenne est un fil hybride (22) associé à au moins un fil non conducteur.

12. Procédé selon la revendication précédente, **caractérisé en ce que** le fil non conducteur (19) entoure au moins par endroit le fil d'antenne.

13. Procédé selon l'une des revendications 11 à 12, **caractérisé en ce que** le fil non conducteur(19) est thermo-fusible ou thermoplastique.

14. Procédé selon la revendication 10, **caractérisé en ce que** la technique de fixation du fil conducteur sur le substrat est choisie parmi la couture, la broderie, l'incrustation.

15. Dispositif comportant une antenne (3) connectée à des plages de contact (5, 6), ledit dispositif comprenant un substrat et une antenne munie de portions terminales (7b, 8b) de connexion reposant sur le substrat (2, 2b, 2f, 15),
ladite antenne étant connectée par soudure (38) à une face soudée des plages de contact (5, 6),
lesdites plages de contact présentent une surface (40) en regard d'une portion terminale de connexion de l'antenne (7b, 8b),
**caractérisé en ce que** les plages de contact présentent une marque de soudage (30) sur une face opposée à ladite face soudée.

16. Dispositif selon la revendication 15, **caractérisé en ce que** l'antenne (3) est réalisée par broderie ou couture sur un support souple (2f) comportant un tissu et **en ce qu'**il comprend un matériau de renfort (15) sous forme de feuille ou couche sur une face du substrat opposée à celle portant les portions terminales.

17. Dispositif l'une des revendications 15 ou 16, **caractérisé en ce qu'**il comprend une cavité (26) dans le substrat et/ou feuille ou couche de renfort à proximité des portions terminales de connexion de l'antenne.

18. Dispositif selon la revendication 17, **caractérisé en ce que** des plages de contact sont associées à un microcircuit (20) et en regard du substrat et de portions terminales de l'antenne reposant sur le substrat, tandis que le microcircuit est inséré au moins en partie dans la cavité (26).

19. Dispositif selon l'une des revendications 15 à 18, **caractérisé, en ce que** les plages comportent une marque de soudage (30) à travers les plages sur une face des plages opposée à celle soudée.

20. Dispositif selon la revendication 15 à 19, **caractérisé en ce qu'**il comporte des perforations(17) dans le matériau de renfort en regard de chaque de portion terminale connectée.

21. Dispositif selon la revendication 15 à 20, **caractérisé en ce qu'**il le fil d'antenne est un fil hybride (22) associé à au moins un fil non conducteur.

22. Dispositif selon la revendication 15 à 21, **caractérisé en ce que** le fil non conducteur est thermo-fusible ou thermoplastique.

23. Produit électronique de communication radiofréquence, tel une carte à puce sans contact, un passeport comprenant le dispositif selon l'une des revendications 15 à 22.

## Patentansprüche

1. Verfahren zur Herstellung einer Vorrichtung, die eine an Kontaktstellen angeschlossene Transponderantenne umfasst, wobei besagtes Verfahren folgende Schritte enthält:
- die Herstellung einer Antenne (3) mit verbindenden Endabschnitten (7b, 8b), die auf einem Träger liegen,
- die Übertragung der Kontaktstellen (5, 6) auf den Träger und deren Verbindung mit den Endabschnitten der Antenne (7b, 8b), wobei die Verbindung in Form einer Schweißung (38) durch Energiezufuhr zwischen den Kontaktstellen (5, 6) und den Endabschnitten (7b, 8b) hergestellt wird,
**dadurch gekennzeichnet, dass** die Kontaktstellen (5, 6) so übertragen werden, dass sie eine Fläche (40) gegenüber einem verbindenden Endabschnitt (7b, 8b) der Antenne bilden, wobei die Schweißenergie direkt auf die Kontaktstellen (5, 6) angewendet wird.

2. Verfahren nach Anspruch 1, **dadurch gekennzeichnet dass** die Antenne durch Aufsticken oder Aufnähen auf einem weichen Träger (2f) mit Gewebe hergestellt wird, und dadurch, dass es einen Schritt enthält, in dem Verstärkungsmaterial (15) in Form einer Folie oder einer Lage an der Seite (36) des Trägers angebracht wird, die der Seite (34) mit den Endabschnitten gegenüberliegt.

3. Verfahren nach Anspruch 2, **dadurch gekennzeichnet, dass** die verstärkende Lage oder Folie nach der Herstellung der Antenne angebracht wird.

4. Verfahren nach einem der vorhergehenden Ansprüche, **dadurch gekennzeichnet, dass** das Verfahren einen Schritt umfasst, in dem ein Hohlraum (26) im Träger und/oder in der verstärkenden Folie oder Lage in der Nähe der verbindenden Endabschnitte (7b, 8b) der Antenne gebildet wird.

5. Verfahren nach Anspruch 4, **dadurch gekennzeichnet, dass** das Verfahren einen Schritt enthält, in dem man die mit einer Mikroschaltung (20) verbundenen Kontaktstellen an eine Stelle gegenüber den verbindenden Endabschnitten (7b, 8b) der Antenne überträgt, wobei die Mikroschaltung zumindest teilweise in den Hohlraum (26) eingefügt wird.

6. Verfahren nach einem der vorhergehenden Ansprüche, **dadurch gekennzeichnet, dass** das Verfahren einen Schritt enthält, in dem man eine Schweißung (38) vom Typ Thermokompressionsbond oder Ultraschallbond herstellt.

7. Verfahren nach Anspruch 6, **dadurch gekennzeichnet, dass** bei der Schweißung eine Auflage (E) benutzt wird, die im Träger Druck gegen die Vertiefung des Endabschnitts der Antenne ausübt.

8. Verfahren nach Anspruch 7, **dadurch gekennzeichnet, dass** die Auflage mindestens in die verstärkende Folie oder Lage (15) gegenüber dem zu verbindenden Endabschnitt ein Loch (17) bohrt, so dass der zu verbindende Endabschnitt (7b, 8b) während der Schweißung von der Auflage gestützt wird,

9. Verfahren nach einem der vorhergehenden Ansprüche, **dadurch gekennzeichnet dass** der Antennendraht (3) mindestens eine isolierende Beschichtung (13) auf seiner gesamten Fläche aufweist und/oder stellenweise mit isolierenden Drähten in Kontakt ist.

10. Verfahren nach einem der vorhergehenden Ansprüche, **dadurch gekennzeichnet, dass** der Antennendraht mithilfe eines nicht stromführenden Drahts (19) am Träger befestigt wird.

11. Verfahren nach einem der vorhergehen Ansprüche, **dadurch gekennzeichnet, dass** der Antennendraht ein Hybriddraht (22) ist, der mit mindestens einem nicht stromführenden Draht kombiniert wird.

12. Verfahren nach dem vorhergehenden Anspruch, **dadurch gekennzeichnet, dass** der nicht stromführende Draht (19) zumindest stellenweise um den Antennendraht gewickelt ist.

13. Verfahren nach einem der Ansprüche 11 bis 12, **dadurch gekennzeichnet dass** der nicht stromführende Draht (19) heißschmelzbar oder thermoplastisch ist.

14. Verfahren nach Anspruch 10, **dadurch gekennzeichnet, dass** die Befestigungstechnik des stromführenden Drahts auf dem Träger in Aufnähen, Aufsticken oder Einlegen besteht.

15. Vorrichtung mit einer Antenne (3), die an Kontaktstellen (5, 6) angeschlossen ist, wobei besagte Vorrichtung einen Träger umfasst und eine Antenne mit verbindenden Endabschnitten (7b, 8b), welche auf dem Träger (2, 2b, 2f, 15) aufliegen,
wobei besagte Antenne durch Schweißung (38) mit einer geschweißten Seite der Kontaktstelle (5, 6) verbunden wird,
wobei besagte Kontaktstellen eine Fläche (40) gegenüber eines verbindenden Endabschnitts der Antenne (7b, 8b) aufweisen,
**dadurch gekennzeichnet, dass** die Kontaktstellen eine Schweißmarke (30) an einer Seite aufweisen, die der besagten geschweißten Seite gegenüber liegt.

16. Vorrichtung nach Anspruch 15, **dadurch gekennzeichnet, dass** die Antenne (3) durch Aufsticken oder Aufnähen auf einem weichen Träger (2f) mit Gewebe hergestellt wird, und dadurch, dass sie ein Verstärkungsmaterial (15) in Form einer Folie oder einer Lage auf der Seite des Trägers aufweist, die der Seite mit den Endabschnitten gegenüberliegt.

17. Vorrichtung nach einem der Ansprüche 15 oder 16, **dadurch gekennzeichnet, dass** sie im Träger und/oder in der verstärkenden Folie oder Lage in der Nähe der verbindenden Endabschnitte der Antenne einen Hohlraum (26) aufweist.

18. Vorrichtung nach Anspruch 17, **dadurch gekennzeichnet, dass** die Kontaktstellen mit einer Mikroschaltung (20) kombiniert sind und sie sich gegenüber dem Träger und auf dem Träger aufliegenden Endabschnitten der Antenne befinden, wohingegen die Mikroschaltung mindestens teilweise in den Hohlraum (26) eingesetzt wird.

19. Vorrichtung nach einem der Ansprüche 15 bis 18, **dadurch gekennzeichnet, dass** die Kontaktstellen eine Schweißmarke (30) über die Kontaktstellen an einer Kontaktstellenseite aufweisen, die der angelöteten Seite gegenüberliegt.

20. Vorrichtung nach Anspruch 15 bis 19, **dadurch gekennzeichnet, dass** sie Perforierungen (17) im Verstärkungsmaterial gegenüber jedes verbundenen Endabschnitts aufweist.

21. Vorrichtung nach Anspruch 15 bis 20, **dadurch gekennzeichnet, dass** der Antennendraht ein Hybriddraht (22) ist, der mit mindestens einem nicht stromführenden Draht kombiniert wird.

22. Vorrichtung nach Anspruch 15 bis 21, **dadurch gekennzeichnet, dass** der nichtleitende Draht heißschmelzbar oder thermoplastisch ist.

23. Elektronisches Radiofrequenz-Kommunikationsprodukt, wie zum Beispiel eine kontaktlose Chipkarte, wobei ein Reisepass die Vorrichtung nach einem der Ansprüche 15 bis 22 enthält.

## Claims

1. A method of making a device including a transponder antenna connected to contact pads, said method comprising the steps of:
- making an antenna (3) having connection end portions (7b, 8b) resting on a substrate;
- transferring the contact pads (5, 6) to the substrate and connecting them to the end portions (7b, 8b) of the antenna, the connection being made in the form of bonding (38) by applying energy between the pads (5, 6) and the end portions (7b, 8b) ;
said method being **characterized in that** the pads (5, 6) are transferred in such a manner that each of them has a surface (40) facing a respective connection end portion (7b, 8b) of the antenna, the bonding energy being applied directly to the pads (5, 6).

2. A method according to claim 1, **characterized in that** the antenna is made by embroidery or sewing on a flexible backing (2f) including a woven fabric, and **in that** it further comprises a step in which a reinforcing material (15) in the form of a sheet or a layer is placed on a face (36) of the substrate that is opposite from the face (34) carrying the end portions.

3. A method according to claim 2, **characterized in that** the reinforcing layer or sheet is put in place after the antenna has been made.

4. A method according to any preceding claim, **characterized in that** the method further comprises a step of forming a cavity (26) in the substrate and/or in the reinforcing sheet or layer in the vicinity of the connection end portions (7b, 8b) of the antenna.

5. A method according to claim 4, **characterized in that** the method further comprises a step in which the contact pads are transferred facing end portions (7b, 8b) of the antenna while being associated with a microcircuit (20), the microcircuit being inserted at least in part into the cavity (26).

6. A method according to any preceding claim, **characterized in that** the method further comprises a step in which bonding (38) of the thermo-compression type or of the ultrasonic type is performed.

7. A method according to claim 6, **characterized in that** the bonding uses an anvil (E) that comes to exert a bearing force opposing penetration of the end portion of the antenna into the backing.

8. A method according to claim 7, **characterized in that** the anvil pierces a hole (17) at least through the reinforcing sheet or layer (15) facing the end portion to be connected, in such a manner that the portion (7b, 8b) to be connected is supported by the anvil during the bonding.

9. A method according to any preceding claim, **characterized in that** the antenna wire (3) has at least one insulating covering (13) over its entire surface and/or is in contact with insulating wires in places.

10. A method according to any preceding claim, **characterized in that** the antenna wire is fastened to the substrate by means of a non-conductive wire (19).

11. A method according to any preceding claim, **characterized in that** the antenna wire is a hybrid wire (22) associated with at least one non-conductive wire.

12. A method according to the preceding claim, **characterized in that** the non-conductive wire (19) surrounds the antenna wire at least in places.

13. A method according to claim 11 or claim 12, **characterized in that** the non-conductive wire (19) is a hot-melt wire, or a thermoplastic wire.

14. A method according to claim 10, **characterized in that** the technique for fastening the conductive wire to the substrate is selected from among sewing, embroidery, and inlaying.

15. A device including an antenna (3) connected to contact pads (5, 6), said device comprising a substrate and an antenna provided with connection end portions (7b, 8b) resting on the substrate (2, 2b, 2f, 15) ;
said antenna being connected by bonding (38) to bonded faces of the contact pads (5, 6);
each of said contact pads having a surface (40) facing a respective connection end portion (7b, 8b) of the antenna;
said device being **characterized in that** each of the contact pads bears a bonding mark (30) on a face opposite from said bonded face.

16. A device according to claim 15, **characterized in that** the antenna (3) is made by embroidery or sewing on a flexible backing (2f) including a woven fabric, and **in that** it further includes a reinforcing material (15) in the form of a sheet or a layer on a face of the substrate that is opposite from the face carrying the end portions.

17. A method according to claim 15 or claim 16, **characterized in that** it further includes a cavity (26) in the substrate and/or in the reinforcing sheet or layer in the vicinity of the connection end portions of the antenna.

18. A device according to claim 17, **characterized in that** contact pads are associated with a microcircuit (20) and facing the substrate and end portions of the antenna resting on the substrate, while the microcircuit is inserted at least in part into the cavity (26).

19. A device according to claim 15 or claim 18, **characterized in that** each of the contact pads bears a bonding mark (30) across it on its face opposite from its bonded face.

20. A device according to any one of claims 15 to 19, **characterized in that** it is provided with holes (17) in the reinforcing material, a respective one of the holes facing each connected end portion.

21. A device according to any one of claims 15 to 20, **characterized in that** the antenna wire is a hybrid wire (22) associated with at least one non-conductive wire.

22. A device according to any one of claims 15 to 21, **characterized in that** the non-conductive wire is a hot-melt wire, or a thermoplastic wire.

23. A radiofrequency communications electronic product, such as a contactless chip card or a passport including the device according to any one of claims 15 to 22.
